# EUROPEAN PATENT APPLICATION

(11) **EP 2 860 281 A1**
(43) Date of publication of application: **15.04.2015**
(21) Application number: 14188268.8
(22) Date of filing: 09.10.2014
(51) Int. Cl.: C23C 18/12, H01L 31/18

(54) **Method of recycling solution, solar cell including buffer layer formed by the method, and deposition apparatus**

(30) Priority: 10.10.2013 KR 20130120863
(71) Applicant: Samsung SDI Co., Ltd., Yongin-si, Gyeonggi-do (KR)
(72) Inventor: Cha, Si-Young, Gyeonggi-do (KR); Ahn, Sang-Hyuck, Gyeonggi-do (KR); Kim, Jeong-Hoon, Gyeonggi-do (KR); Kim, Hyun-Chul, Gyeonggi-do (KR); Baik, Nam-Seok, Gyeonggi-do (KR)
(74) Representative: Mounteney, Simon James

(57) **Abstract**

A method of recycling a solution, the method including: filtering a solution used in chemical bath deposition; reinflowing the filtered solution to a bath; and inflowing an alkali solution to the bath to maintain a concentration of an alkaline material in the filtered solution in a range of about 1.0 M to about 3.5 M, is disclosed. A solar cell formed by the method and a deposition apparatus are also disclosed. By the method of recycling a solution, a solar cell including a buffer layer formed with a solution which has been used multiple times may be formed to have an efficiency almost the same as that of a solar cell including a buffer layer formed with a solution provided for the first time before filtering.

## Description

### BACKGROUND

### 1. Technical Field

One or more aspects according to embodiments of the present invention relate to a method of recycling a solution, a solar cell including a buffer layer formed by the method, and a deposition apparatus.

### 2. Description of the Related Art

As exhaustion (or depletion) of conventional energy resources such as petroleum and coal is anticipated, increasing attention has been given to various alternative energy resources which may substitute for conventional energy resources (e.g., fossil fuels). Among such alternative energy resources, solar cells using a p-n junction of a semiconductor device have drawn attention as next-generation solar cells capable of directly converting sunlight energy into electric energy.

Solar cells may be classified according to a material, and may be classified as, for example, a crystalline or an amorphous silicon solar cell, a compound solar cell, or a dye-sensitized solar cell. Currently, crystalline silicon solar cells the most widely used solar cells. However, crystalline silicon solar cells have drawbacks in that they have a high unit cost when compared to their power generation efficiency, and the processes for manufacturing such solar cells are complicated. Thus, to overcome those drawbacks, increasing attention has been paid to thin film solar cells, which cost less to manufacture. For example, more studies have been conducted on thin film solar cells that are prepared using a CIS (Cu-In-Se) or CIGS (Cu-In-Ga-Se) compound semiconductor, each of which has a relatively high photoelectric conversion efficiency.

A CIS solar cell includes a p-n junction between a light-absorbing layer including a CIS compound, a transparent electrode layer on the light-absorbing layer and a buffer layer between the light-absorbing layer and the transparent electrode layer. Conventionally, cadmium sulfide (CdS) was used to form the buffer layer. However, as CdS includes cadmium (Cd), which is harmful to humans, studies have recently been conducted on forming a buffer layer using zinc sulfide (ZnS).

However, when a buffer layer is formed by chemical bath deposition, a process solution for forming the buffer layer is usually used a plurality of times in a wet treatment. A solar cell including a buffer layer formed with a process solution reused a plurality of times may have a low efficiency. Therefore, it is advantageous to solve such a problem.

### SUMMARY

One aspect according to an embodiment of the present invention relates to a method of recycling a solution that enables manufacture of a solar cell that includes a buffer layer formed with a solution which has been used multiple times, the solar cell having an efficiency almost the same (e.g., substantially the same) as that of a solar cell including a buffer layer formed with a solution provided for the first time before filtering. According to an embodiment of the present invention, a method of recycling a solution includes: filtering a solution used in chemical bath deposition; reinflowing the filtered solution to a bath; and inflowing an alkali solution to the bath to maintain a concentration of an alkaline material in the filtered solution in a range of about 1.0 M to about 3.5 M.

Another aspect according to an embodiment of the present invention relates to a solar cell including a buffer layer formed by the method of recycling a solution. Another aspect according to an embodiment of the present invention provides a process for preparing a solar cell comprising a buffer layer comprising the method of recycling a solution of the present invention or using a deposition apparatus of the present invention.

Another aspect according to an embodiment of the present invention relates to a deposition apparatus that enables manufacture of a solar cell that includes a buffer layer formed with a solution which has been used multiple times, the solar cell having an efficiency almost the same (e.g., substantially the same) as that of a solar cell including a buffer layer formed with a solution provided for the first time before filtering. According to an embodiment of the present invention, a deposition apparatus includes: a bath configured to accommodate a solution used in chemical bath deposition; a first tank configured to temporarily store the solution; a first pipe coupled to a first drain pump, the first pipe being configured to inflow the solution used in chemical bath deposition from the bath to the first tank; a filter part coupled to the first tank and configured to filter the solution stored in the first tank to provide a filtered solution; a second pipe coupled to the first tank, the bath, and a circulation pump, the second pipe being configured to reinflow the filtered solution from the first tank to the bath; and a third pipe coupled to a second tank, the bath, and a second drain pump, the third pipe being configured to inflow an alkali solution from the second tank to the bath and to provide the alkali solution to the filtered solution.

Additional aspects will be set forth in part in the description which follows and, in part, will be apparent from the description, or may be learned by practice of the presented embodiments.

### BRIEF DESCRIPTION OF THE DRAWINGS

These and/or other aspects will become more apparent and more readily appreciated by reference to the following description of the embodiments, taken in conjunction with the accompanying drawings in which:
FIG. 1 is a flow chart illustrating a process of a method of recycling a solution used in chemical bath deposition according to an embodiment of the present invention;
FIG. 2 is a schematic cross-sectional diagram of a solar cell according to an embodiment of the present invention;
FIG. 3 is a schematic diagram of a deposition apparatus according to an embodiment of the present invention;
FIG. 4 shows variation of NH₄OH concentration in a conventionally filtered solution used in chemical bath deposition analyzed with an ion chromatography instrument;
FIG. 5 shows a relative efficiency ratio of a solar cell employing a buffer layer which is formed by continuously using a filtered solution used in chemical bath deposition according to an embodiment of the present invention; and
FIG. 6 shows a relative efficiency ratio of a solar cell employing a buffer layer which was formed by continuously using a conventionally filtered solution used in chemical bath deposition.

### DETAILED DESCRIPTION

Reference will now be made in more detail to certain embodiments, examples of which are illustrated in the accompanying drawings, wherein like reference numerals refer to like elements throughout. In this regard, the present embodiments may have different forms and should not be construed as being limited to the descriptions set forth herein. Accordingly, certain embodiments are described below, by referring to the figures, to explain aspects of the present description. As used herein, the term "and/or" includes any and all combinations of one or more of the associated listed items.

One aspect according to an embodiment of the present invention provides a method of recycling a solution, the method including: filtering a solution used in chemical bath deposition; reinflowing (i.e. reintroduce) the filtered solution to a bath, preferably the same bath where the chemical bath deposition was carried out; and inflowing (i.e. introduce) an alkali solution to the bath to maintain a concentration of an alkaline material in the filtered solution in a range of about 1.0 M to about 3.5 M.

Another aspect according to an embodiment of the present invention provides a solar cell including a buffer layer formed by the method of recycling the solution. Another aspect according to an embodiment of the present invention provides a process for preparing a solar cell comprising a buffer layer comprising the method of recycling a solution of the present invention or using a deposition apparatus of the present invention.

Another aspect according to an embodiment of the present invention provides a deposition apparatus including: a bath configured to accommodate a solution used in chemical bath deposition; a first tank configured to temporarily store the solution; a first pipe coupled to a first drain pump, the first pipe being configured to inflow the solution used in chemical bath deposition from the bath to the first tank; a filter part coupled to the first tank and adapted to filter the solution stored in the first tank to provide a filtered solution; a second pipe coupled to the first tank, the bath, and a circulation pump, the second pipe being configured to reinflow the filtered solution from the first tank to the bath; and a third pipe coupled to a second tank, the bath, and a second drain pump, the third pipe being configured to inflow an alkali solution from the second tank to the bath and to provide the alkali solution to the filtered solution.

Hereinafter, an embodiment of a method of recycling a solution, a solar cell including a buffer layer formed by the method, and a deposition apparatus according to an embodiment of the present invention are described in more detail. However, as it is presented as an example, the present invention is not limited thereto and the present invention is defined only by the scope of the appended claims, and equivalents thereof.

In the drawings, each component or feature may be magnified, omitted or schematically shown for the purpose of convenience and clarity of description. The size of each component may not necessarily correspond to its actual size.

In describing each component, it will be understood that, when a component is referred to as being "on" another component, "on" includes "directly" or "indirectly". For example, in the context of the present application, when a first element is referred to as being "on" a second element, it can be directly on the second element or be indirectly on the second element with one or more intervening elements therebetween. Further, the term "on" is used with reference to the drawings, but the present disclosure is not limited thereto and, for example "on" can mean "below."

While terms such as "first" and "second," etc., may be used to describe various components, such components must not be limited to the above terms. The above terms are used only to distinguish one component from another. The terms used in the present specification are merely used to describe particular embodiments, and are not intended to limit the present invention. In the present application, an expression used in the singular encompasses the expression of the plural, unless it has a clearly different meaning in the context. In the present specification, it is to be understood that terms such as "including" or "having," etc., are intended to indicate the existence of the features, numbers, steps, actions, components, parts, or combinations thereof disclosed in the specification, and are not intended to preclude the possibility that one or more other features, numbers, steps, actions, components, parts, or combinations thereof may exist or may be added.

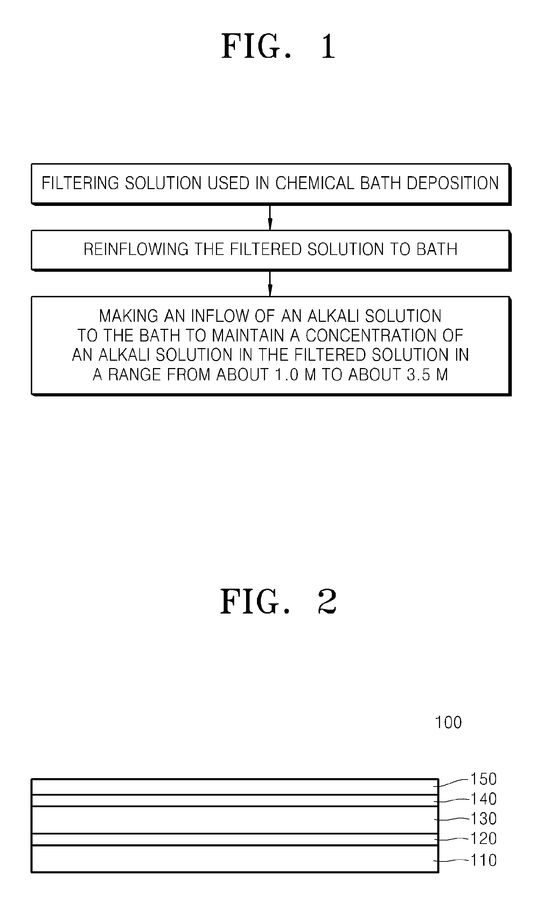

FIG. 1 is a flow chart illustrating a process of a method of recycling a solution used in chemical bath deposition according to an embodiment of the present invention.

Firstly, a substrate on which a light-absorbing layer is formed is dipped into a bath filled with a solution used in chemical bath deposition. A buffer layer is formed on the substrate on which the light-absorbing layer is formed.

Generally, a substrate on which a buffer layer is formed is taken out of the bath and then a new substrate on which a buffer layer is to be formed is dipped into the solution.

However, as the number of times of using the solution increases (e.g., as the number of uses of the solution or number of substrates dipped in the solution increases), the concentration of impurities, such as zinc sulfide, cadmium sulfide, zinc oxide, and/or cadmium oxide, in the solution increases. Because the impurities attach to the substrate during the process of forming the buffer layer, increasing the concentration of impurities in the solution increases the amount of impurities that attach to the substrate and negatively effects properties of a solar cell including substrate and buffer layer, thereby decreasing the efficiency of the solar cell.

Thus, to minimize or reduce the negative effects of the impurities on the resultant solar cell, the solution can be substituted with a new solution for each new chemical bath deposition (e.g., the solution can be replaced with a new solution before each new substrate is dipped). However, in the case of mass production of solar cells, substituting the solution with a new solution before each new substrate is dipped causes time and cost problems. Therefore, a solution used for a chemical bath deposition procedure may be filtered (or repeatedly filtered) to be recycled.

However, when the solution is filtered repeatedly (e.g., three times or more), a solar cell including a buffer layer formed from the filtered solution may have low efficiency. The main cause of the decrease in the efficiency of the solar cell formed after repeated filtering of the solution is a reduction of the concentration of an alkaline material in the solution. The concentration of the alkaline material is reduced as a result of the alkaline material reacting with metal ions on a surface of the light-absorbing layer, to clean impurities from the light-absorbing layer (e.g., reduce the amount of impurities on the light-absorbing layer). Additionally, the concentration of the alkaline material is reduced because the alkaline material is continuously volatilized from the solution initially provided before filtering and a reaction rate change of the concentration of the alkaline material is the greatest of the components included in the solution.

A method of recycling a solution according to an embodiment of the present invention includes: filtering a solution used in chemical bath deposition to provide a filtered solution; reinflowing the filtered solution to a bath; and inflowing an alkali solution to the bath to maintain a concentration of an alkaline material in the filtered solution in a range of about 1.0 M to about 3.5 M. For example, a concentration of the alkaline material in the filtered solution may be in a range of about 1.5 M to about 3.5 M or about 1.75M to about 3.0M.

The amount of the alkali solution flowing into the bath may be in a range of about 5 parts by weight to about 15 parts by weight, based on 100 parts by weight of the alkaline material in the solution. For example, the amount of the alkali solution flowing into the bath may be about 5 parts by weight to about 12 parts by weight or about 7 parts by weight to about 10 parts by weight with respect to 100 parts by weight of the alkaline material existing in the solution. The concentration of an alkaline material in the alkali solution flowing into the bath may be in a range of about 0.125 M to about 0.5 M. For example, the concentration of the alkaline material of the alkali solution flowing into the bath may be about 0.125 M to about 0.3 M or about 0.15 M to about 0.25 M.

While the amount and/or concentration of the alkali solution flowing into the bath are in the ranges described above, even in a case when a solution is recycled a plurality of times, for example, three times or more, a solar cell including a buffer layer formed with the recycled solution may have an efficiency almost the same (e.g., substantially the same) as that of a solar cell including a buffer layer formed with a solution provided for the first time before filtering. Additional details with respect to NH₄OH concentration change in a solution used in chemical bath deposition and solar cell efficiency will be provided below.

A light transmittance of a solution including an alkaline material in the amount and/or concentration ranges described above may be about 60% or higher. Herein, the "light transmittance" of the solution refers to a light transmittance at a time when a process by a chemical bath deposition has been completed. An efficiency of a solar cell including a buffer layer formed with a solution having a light transmittance of about 60% or higher may not be affected and the solution used in a chemical bath deposition may be recycled.

The solution used in chemical bath deposition may include a sulfur source, a zinc source, and/or an alkaline material, but the solution is not limited thereto. The sulfur source may include, for example, a thiourea compound, but the sulfur source is not limited thereto. The sulfur source allows for forming a uniform (or substantially uniform) buffer layer on the light-absorbing layer. The concentration of the sulfur source in the solution may be in a range of, for example, about 0.2 M to about 1.3 M.

The zinc source may include, for example, a zinc salt or a zinc compound, for example, a zinc sulfate aqueous solution or zinc sulfate hydrate (e.g., ZnSO₄.H₂O), but the zinc source is not limited thereto. As the zinc source is sufficiently substituted and diffused into a surface of the light-absorbing layer, a buffer layer may grow progressively. The concentration of the zinc source in the solution may be in a range of, for example, about 0.01 M and to about 0.1 M.

The alkaline material may include, for example, an ammonia compound, but the alkaline material is not limited thereto. For example, the alkaline material may include ammonia or an ammonia aqueous solution (e.g., a solution including ammonium hydroxide or NH₄OH). Such an alkaline material may not only react with metal ions on a surface of the light-absorbing layer to clean impurities from the light-absorbing layer (e.g., reduce the amount of impurities on the light-absorbing layer), but the alkaline material may also form a copper ammonia complex such as [Cu(NH₄)₃]²⁺ or [Cu(NH₄)₂]²⁺ at CuₓSe or Cu rich sites to control a shunt path and improve band alignment properties.

In addition, the ammonia or NH₄OH may be bound to Zn²⁺ as a ligand and induce a binding between the Zn and a surface of the light-absorbing layer. The ammonia or an ammonia aqueous solution (e.g., NH₄OH) may control a rate of forming a buffer layer on the light-absorbing layer.

A temperature of the solution used in chemical bath deposition may be in a range of about 60 °C to about 80 °C. Within the foregoing temperature range, a buffer layer may be continuously formed on a substrate on which a light-absorbing layer is formed (e.g., a continuous buffer layer may be formed on the light-absorbing layer). Additionally, within the foregoing temperature range, manufacturing costs are reduced, and environmental problems related to waste solution treatment are addressed.

FIG. 2 is a schematic cross sectional diagram of a solar cell according to an embodiment of the present invention.

As shown in FIG. 2, a solar cell (100) may include a backside electrode layer (120), a light-absorbing layer (130), a buffer layer (140), and a transparent electrode layer (150) laminated in order (e.g., sequentially) on a substrate (110).

The substrate (110) may include (or be formed with) glass or a polymer material having excellent transparency, but the substrate is not limited thereto. For example, soda lime glass may be used as a glass substrate (e.g., the substrate) and polyimide may be used as a polymer substrate (e.g., the substrate), but the substrate is not limited thereto. In addition, the substrate may be a glass substrate may include (or be formed with) low iron tempered glass including a low content of iron in order to protect an inner device from external impact and increase solar light transmittance. For example, in the case of low iron tempered glass, Na ions of the glass can be dissolved out at a process temperature higher than 500 °C, thereby further improving an efficiency of the light-absorbing layer (130) formed with CIGS.

A backside electrode layer (120) may include (or be formed with) metal materials having high conductivity and light reflecting rate (e.g., light reflectance), such as molybdenum (Mo), aluminum (Al) or Copper (Cu), to collect electric current formed by a photoelectric effect and to reflect light transmitted through the light-absorbing layer (130) so that the light may be absorbed by the light-absorbing layer (130). For example, considering the high conductivity of molybdenum (Mo), its ability to form an ohmic contact with the light-absorbing layer (130), and its high temperature stability in a selenium (Se) atmosphere, the backside electrode layer (120) may be formed to include molybdenum (Mo).

In addition, an alkali ion, such as Na, may be doped into the backside electrode layer (120). For example, during growth of a CIGS light-absorbing layer (130), which will be described in more detail below, an alkali ion doped into the backside electrode layer (120) may mix with the light-absorbing layer (130) to provide a structurally advantageous effect on the light-absorbing layer (130) and to improve conductivity of the light-absorbing layer (130). As a result, an open circuit voltage (V_{oc}) of the solar cell (100) may be increased to improve the efficiency of the solar cell (100).

In addition, the backside electrode layer (120) may be formed as multiple layers (e.g., a plurality of layers) in order to provide (or secure) suitable adherence with the substrate (110), and/or to provide (or secure) suitable resistance properties of the backside electrode layer (120) itself.

The light-absorbing layer (130) includes (or is formed with) a copper-indium-selenium (CIS) compound including copper (Cu), indium (In), and selenium (Se) to form a p-type semiconductor layer and to absorb incident solar light. In addition, the light-absorbing layer (130) may further include a copper-indium-gallium-selenide (Cu(In, Ga)Se₂, CIGS) compound including copper (Cu), indium (In), gallium (Ga), and selenium (Se).

The light-absorbing layer (130) may be formed by co-evaporation in which, for example, copper (Cu), indium (In), gallium (Ga), and selenium (Se) are put into a small electric furnace installed in a vacuum chamber and heated to perform vacuum evaporation. The light-absorbing layer (130) may also be formed by a sputtering/selenization method in which a CIG metal precursor layer is formed on the backside electrode layer (120) by using a copper (Cu) target, an indium (In) target, and a gallium (Ga) target and then the CIG metal precursor layer is heat-treated in a hydrogen selenide (H₂Se) gas atmosphere to form a CIGS light-absorbing layer (130) as the CIG metal precursor layer reacts with selenium. In addition, the light-absorbing layer (130) may be formed by electro-deposition or by molecular organic chemical vapor deposition (hereinafter referred to as "MOCVD").

The buffer layer (140) decreases a band gap between the light-absorbing layer (130) and the transparent electrode layer (150) and reduces recombination of electrons and positive holes, which may occur at the interface between the light-absorbing layer (130) and the transparent electrode layer (150). The buffer layer (140) may be formed by the method of recycling a solution described above. The buffer layer (140) may include, for example, ZnS or ZnS(O, OH), but the buffer layer is not limited thereto.

The buffer layer (140) may be formed on the light-absorbing layer (130), for example, according to the following embodiment. After putting the solution, which includes a sulfur source, a zinc source, and an alkaline material, into a bath, a substrate on which the light-absorbing layer (130) is to be formed is dipped into the bath at a temperature of about 60 °C for about 15 minutes. The substrate is then washed at room temperature with deionized (DI) water three times or more for about two minutes each time and then the substrate is dried in a N₂ gas atmosphere for about seven minutes to form the buffer layer (140) on the light-absorbing layer (130).

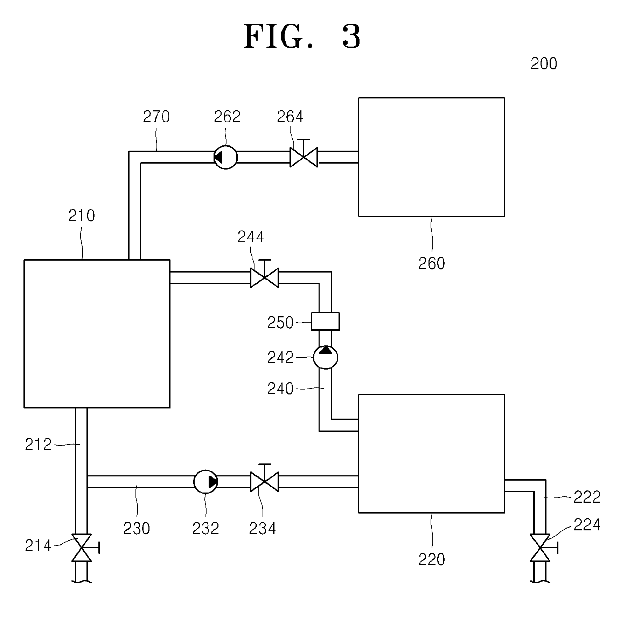

The buffer layer (140) may also be formed by chemical bath deposition using a deposition apparatus as schematically illustrated in FIG. 3. Embodiments of the method will be described in more detail below.

The transparent electrode layer (150) forms a p-n junction with the light-absorbing layer (130). The transparent electrode layer (150) includes (or is formed with) a transparent conductive material such as ZnO:B, ZnO:Al, ZnO:Ga, indium tin oxide (ITO) or indium zinc oxide (IZO) to capture an electric charge formed by a photoelectric effect, but the transparent electrode layer is not limited thereto.

An upper surface of the transparent electrode layer (150) may be textured to reduce reflection of incident solar light and to increase light absorption by the light-absorbing layer (130).

The solar cell (100) may be divided into multiple solar cell units (e.g., a plurality of solar cell units) by a first scribing process separating (or dividing) the transparent electrode layer (150) into sections, a second scribing process separating (or dividing) the light-absorbing layer (130) and the buffer layer (140) into sections, and a third scribing process separating (or dividing) the transparent electrode layer (150) into sections, the light-absorbing layer (130) and the buffer layer (140). The multiple solar cell units may be coupled to each other in series.

FIG. 3 is a schematic diagram of a deposition apparatus according to an embodiment of the present invention.

As shown in FIG. 3, the deposition apparatus (200) according to an embodiment of the present invention may comprise a bath (210) which is filled with a solution to form a buffer layer (e.g., the buffer layer 140 shown in FIG. 2), a first tank (220) in which a solution used in chemical bath deposition is temporarily stored, a filter part (250) configured to filter the solution stored in the first tank (220), and a second tank (260) configured to provide an alkali solution to the filtered solution.

The bath (210) may employ a heater to maintain the temperature of the solution in a range of about 60 °C to about 80 °C.

The temperature of the first tank (220) may be maintained to be higher than that of the bath (210). The purpose of the higher temperature of the first tank (220) is to compensate for a drop in the temperature of the first tank (220) including the heater at the time when the solution used in chemical bath deposition is reinflowed into the bath (210) through a second pipe (240). For example, the temperature of the solution used in chemical bath deposition which is transferred to the first tank (220) may be maintained at a temperature higher than that of forming a layer temperature by about 2 °C to about 10 °C, for example at about 62°C to about 90 °C. The solution having an increased temperature is transferred through the second pipe (240) and filtered by the filter part (250).

The bath (210) and the first tank (220) are coupled to each other by a first pipe (230). The solution used in the process may be transferred from the bath (210) to the first tank (220) through the first pipe (230). On the other hand, to prevent (or reduce) a back flowing of the solution used in the process, a first drain pump (232) and a first valve (234) are coupled to (or formed on) the first pipe (230).

When the solution used in the process is being transferred from the bath (210) to the first tank (220) through the first pipe (230), a second valve (244) is closed, and the first valve (234) is open. In other words, in some embodiments, the first valve (234) and the second valve (244) are operated mutually exclusively. Thus, all (or substantially all) of the solution pumped (or used) by the first drain pump (232) is transferred to the first tank (220) through the first pipe (230).

The solution temporarily stored in the first tank (220) is transferred through the filter part (250) and flowed into the bath (210) again. The filter part (250) is coupled to (or formed on) the second pipe (240) coupling the first tank (220) and the bath (210). To prevent (reduce) a back flow of the filtered solution, a circulation pump (242) and the second valve (244) are formed on the second pipe (240).

As a drain pipe (222) is formed on one side of the first tank (220) to drain a solution to be disposed. A drain valve (224) is formed on the drain pipe (222). When a solution is disposed, a solution to be used for a new chemical bath deposition fills the bath (210) through a fourth pipe (212).

At that time, the first valve (234) is closed, while the second valve (244) is open. The solution stored in the first tank (220) is inflowed by the circulation pump (242) through the second pipe (240) to the bath (210). In other words, when the solution is transferred, the first valve (234) and the second valve (244) are operated exclusively.

The filter part (250) preferably includes a porous filter formed with polypropylene (PP), polyethersulfone (PES), Teflon (PTFE), nylon, and the like. The diameter of the pores of the filter may be in a range from about 0.2 *µ*m to about 5 *µ*m, but not limited thereto. The filter part (250) filters the solution stored in the first tank (220) to eliminate impurities.

While the filter part (250) is illustrated as a single filter part (250) in FIG. 3, the number of filter part (250) is not limited thereto. Two or three or more filter parts (250) may be included.

In addition, as filtering performed after completely transferring the solution to the first tank (220) may prevent (reduce) mixing of the filtered solution and the previous solution, time required for filtering may be reduced. In addition, when filtering is performed during a chemical bath deposition process without transfer of the solution to the first tank (220), a flow of the solution is continuously generated in the bath (210) and, as a result, the thickness of the buffer layer (140 in FIG. 2) may be prevented from becoming uneven (or an amount or likelihood of such unevenness may be reduced).

At the top of the bath (210), the second tank (260) providing an alkali solution is coupled to a third pipe (270). The alkali solution may be transferred to the bath (210) through the third pipe (270). On the other hand, to prevent (or reduce) a back flowing of the solution used in the process, a second drain pump (262) and a third valve (264) are formed on the third pipe (270).

At that time, the first valve (234) is closed, while the third valve (264) is open. The solution stored in the second tank (260) is entered into the bath (210) through the third pipe (270). In other words, when the solution is transferred, the first valve (234), the second valve (244), and the third valve (264) are operated exclusively. When the amount of the inflowing alkali solution becomes in a range from about 5 parts by weight to about 15 parts by weight, for examples, 5 parts by weight to about 12 parts by weight, with respect to 100 parts by weight of the alkaline material existing in the solution in the bath (210), the third valve (264) is closed.

On the other hand, the bath (210) is coupled to a fourth pipe (212). A fourth valve (214) is coupled to (or formed on) the fourth pipe (212). The solution may be injected to the bath (210) or drained externally through the fourth pipe (212).

### Change in NH₄OH concentration in solution used in chemical bath deposition

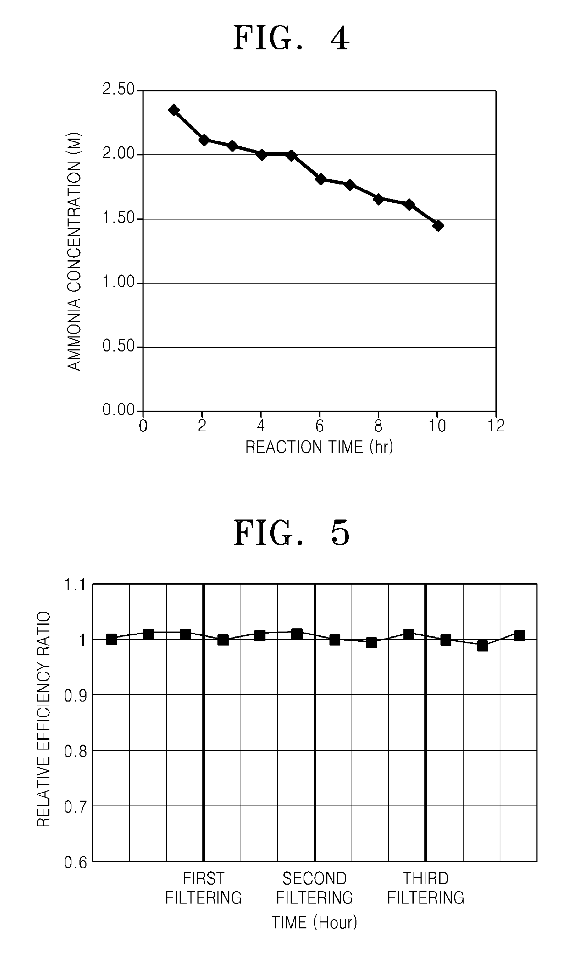

FIG. 4 shows a change in the NH₄OH concentration in the conventionally filtered solution used in chemical bath deposition as analyzed by ion chromatography (analyzed using a Model: ICS2000 ion chromatograph, available from Mitsubishi Chemical Corporation). Each of the dots (e.g., data points) in FIG. 4 represents a number of times of recycling the solution used in chemical bath deposition over time (with the solution being recycled one time per hour of reaction time), indicating that the solution was recycled from one time to ten times. The initial NH₄OH concentration in the solution to be used in chemical bath deposition was 2.5 M.

As shown in FIG. 4, after using the solution one time, the NH₄OH concentration was in a range of about 2.411 M to about 2.413 M. The result showed that the NH₄OH concentration in the solution after being used one time was reduced about 4% ± 0.5% with respect to the initial NH₄OH concentration.

### Solar cell efficiency

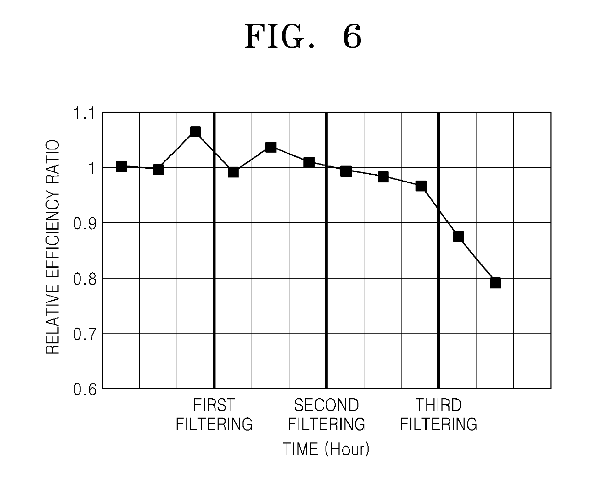

FIG. 5 shows efficiencies of solar cells employing buffer layers formed by continuously using a filtered solution used in chemical bath deposition according to an embodiment of the present invention. FIG. 6 shows efficiencies of solar cells employing buffer layers formed by continuously using a conventionally filtered solution used in chemical bath deposition.

The results shown in FIGS. 5 and 6 were obtained by filtering each solution three times. Prior to each filtering, each solution was used to prepare a buffer layer on each of five substrates. FIGS. 5 and 6 show the efficiencies measured for two sets of solar cells (100 in FIG. 2) respectively including first, third, and fifth substrates prepared before a first filtering of each solution, first, third, and fifth substrates prepared between the first filtering and a second filtering of each solution, first, third, and fifth substrates prepared between the second filtering and a third filtering of each solution, first, third, and fifth substrates prepared after the third filtering of the solution filtered according to an embodiment of the present invention (FIG. 5), and first and third substrates prepared after the third filtering of the conventionally filtered solution (FIG. 6). In FIGS. 5 and 6, the relative efficiency ratios were measured with respect to a solar cell (100 in FIG. 2) prepared using the first substrate prepared before the first filtering of the solution filtered according to an embodiment of the present invention and a solar cell prepared using the first substrate prepared before the first filtering of the conventionally filtered solution, respectively.

In FIG. 5, the amount of NH₄OH entering into the bath was in a range from about 5 parts by weight to about 12 parts by weight with respect to 100 parts by weight of the NH₄OH existing in the solution, in other words, the NH₄OH concentration of the solution inflowing into the bath was in a range of about 0.125 M to about 0.3 M. Thus, when recycling the solution used in chemical bath deposition, the NH₄OH concentration of the solution was maintained at about 2.5M ± 0.1 M.

As shown in FIG. 5, the relative efficiency ratio of a solar cell (100 in FIG. 2) prepared using the first substrate (110 in FIG. 2) before the first filtering of the solution to that of a solar cell (100 in FIG. 2) prepared by using the first substrate (110 in FIG. 2) after the third filtering of the solution was about 1, indicating that the solar cell efficiency was almost the same (i.e., substantially the same).

As shown in FIG. 6, the relative efficiency ratio of a solar cell (100 in FIG. 2) prepared using the first substrate (110 in FIG. 2) after the third filtering of the conventionally filtered solution was about 0.8 to about 0.9, indicating that the solar cell efficiency was reduced with respect to that of the solar cell (100 in FIG. 2) prepared using the first substrate (110 in FIG. 2) before the first filtering of the conventionally filtered solution. Without being limited by theory, the foregoing was, in part, because the concentration of the alkaline material in the solution used in chemical bath deposition was decreased and the composition of the solution was changed.

Although certain embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

As described above, according to one or more of the above embodiments of the present invention, by a method of recycling a solution including maintaining a concentration of an alkaline material in the filtered solution in a range of about 1.0 M to about 3.5 M by inflowing an alkali solution into the bath and by the deposition apparatus, a solar cell including a buffer layer formed with the filtered solution, which has been used multiple times, may have an efficiency almost the same (e.g., substantially the same) as that of a solar cell including a buffer layer formed with a solution provided for the first time before filtering.

It should be understood that the embodiments described herein should be considered in a descriptive sense only and not for purposes of limitation. Descriptions of features or aspects within each embodiment should typically be considered as being available for other similar features or aspects in other embodiments.

While one or more embodiments of the present invention have been described with reference to the figures, it will be understood by those of ordinary skill in the art that various changes in form and details may be made therein without departing from the scope of the present invention as defined by the following claims, and equivalents thereof. Throughout the text and claims, use of the word "about" reflects the penumbra of variation associated with measurement, significant figures, and interchangeability, all as understood by a person having ordinary skill in the art to which this disclosure pertains. Additionally, throughout this disclosure and the accompanying claims, it is understood that even those ranges that may not use the term "about" to describe the high and low values are also implicitly modified by that term, unless otherwise specified.

## Claims

1. A method of recycling a solution, the method comprising:
filtering a solution used in chemical bath deposition;
reinflowing the filtered solution to a bath; and
inflowing an alkali solution to the bath to maintain a concentration of an alkaline material in the filtered solution in a range of about 1.0 M to about 3.5 M.

2. The method of recycling a solution of claim 1, wherein an amount of the alkali solution inflowing into the bath is in a range of about 5 parts by weight to about 15 parts by weight, based on 100 parts by weight of an alkali solution existing in the solution.

3. The method of recycling a solution of claim 1 and claim 2, wherein the concentration of an alkaline material in the alkali solution flowing into the bath is in a range of about 0.125 M to about 0.5 M.

4. The method of recycling a solution of any of claims 1 to 3, wherein the solution used in chemical bath deposition includes a sulfur source, a zinc source, and an alkaline material.

5. The method of recycling a solution of claim 4, wherein the sulfur source comprises a thiourea compound.

6. The method of recycling a solution of claim 4 and claim 5, wherein the zinc source comprises a zinc salt or a zinc compound.

7. The method of recycling a solution of any of claims 4 to 6, wherein the alkaline material comprises an ammonia compound.

8. The method of recycling a solution of any of claims 1 to 7, wherein the temperature of the solution used in chemical bath deposition is in a range of about 60 °C to about 80 °C.

9. The method of recycling a solution of any of claims 1 to 8, wherein the temperature of the solution prior to filtering is higher than when the solution is in the bath, optionally higher by about 2 °C to about 10 °C.

10. The method of recycling a solution of any of claims 1 to 9, wherein the alkaline material in the inflowing alkali solution comprises an ammonia compound.

11. A solar cell comprising a buffer layer formed by the method of recycling a solution of any of claims 1 to 10, optionally wherein the buffer layer comprises ZnS or ZnS(O,OH) and/or wherein the solar cell comprises a light-absorbing layer of a copper-indium-gallium-selenide (CIGS) compound.

12. A deposition apparatus comprising:
a bath configured to accommodate a solution used in chemical bath deposition;
a first tank configured to temporarily store the solution;
a first pipe coupled to a first drain pump, the first pipe being configured to inflow the solution used in chemical bath deposition from the bath to the first tank;
a filter part coupled to the first tank and configured to filter the solution stored in the first tank to provide a filtered solution;
a second pipe coupled to the first tank, the bath, and a circulation pump, the second pipe being configured to reinflow the filtered solution from the first tank to the bath; and
a third pipe coupled to a second tank, the bath, and a second drain pump, the third pipe being configured to inflow an alkali solution from the second tank to the bath and to provide the alkali solution to the filtered solution.

13. The deposition apparatus of claim 12, wherein a first valve is coupled to the first pipe, a second valve is coupled to the second pipe, and a third valve is coupled to the third pipe; and
wherein the first valve, the second valve, and the third valve are operated independently when the solution is transferred.

14. The deposition apparatus of claim 12 or claim 13, wherein the deposition apparatus is configured to form a buffer layer of a solar cell by chemical bath deposition.

15. A process for preparing a solar cell comprising a buffer layer comprising the method of recycling a solution as claimed in any of claims 1 to 10 or using a deposition apparatus as claimed in any of claims 12 to 14, optionally, wherein the solar cell comprises a light-absorbing layer of a copper-indium-gallium-selenide (CIGS) compound and/or the buffer layer comprises ZnS or ZnS(O,OH).
